# EUROPEAN PATENT SPECIFICATION

(11) **EP 0 240 307 B1**
(45) Date of publication and mention of the grant of the patent: **22.12.1993**
(21) Application number: 87302784.1
(22) Date of filing: 31.03.1987
(51) Int. Cl.: H01L 29/08, H01L 29/73

(54) **Bipolar transistor and method of producing the same**
Bipolarer Transistor und sein Herstellungsverfahren
Transistor bipolaire et son procédé de fabrication

(30) Priority: 01.04.1986 JP 74738/86; 12.05.1986 JP 107936/86; 19.08.1986 JP 193294/86; 01.12.1986 JP 286323/86
(43) Date of publication of application: 07.10.1987
(60) Divisional application: 93107043.7
(73) Proprietor: MATSUSHITA ELECTRIC INDUSTRIAL CO., LTD., Kadoma-shi, Osaka-fu, 571 (JP)
(72) Inventor: Inada, Masanori, Ikoma-gun Nara-ken, 636 (JP); Eda, Kazuo, Hirakata-shi Osaka-fu, 573 (JP); Ota, Yorito, Kobe-shi Hyogo-ken, 652 (JP); Nakagawa, Atsushi, Kawanishi-shi Hyogo-ken, 666 (JP); Yanagihara, Manabu, Kadoma-shi Osaka-fu, 571 (JP)
(74) Representative: Crawford, Andrew Birkby

(56) References cited:
- JAPANESE JOURNAL OF APPLIED PHYSICS SUPPLEMENTS, vol. 22, no. 22-1, 1983, pages 375-380, Tokyo, Japan ; J.S. HARRIS et al. : "(Invited) Heterojunction Bipolar Transistors"
- IEEE ELECTRON DEVICE LETTERS, vol. EDL-3, no. 12, December 1982, pages 366-368, New York, USA ; P.M. ASBECK et al. : "GaAs/GaA1As Heterojunction Bipolar Transistors with Cutoff Frequencies Above 10 GHz"
- INST. PHYS. CONF. SER., no. 79, chapter 11, 1985, pages 589-594, International Symposium on GaAs and Related Compounds, Karuizawa, Japan ; K. NAGATA et al. : "A new self-aligned structure A1GaAs/GaAs HBT for high speed digital circuits"

## Description

### BACKGROUND OF THE INVENTION

### 1. Field of the Invention

This invention relates to a method of forming bipolar transistor which is highly expected as a superhigh-speed, superhigh-frequency device.

### 2. Description of the Prior Art

Parameters of high speed action, f_{T} and fm, of a bipolar transistor (BT) are expressed as follows. 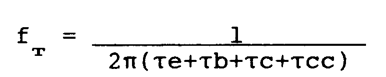
$\text{fm = √} \overline{{\text{f}}_{\text{T}} \text{/}} \text{√} \overline{\text{8πRbCbc}}$

where τe (emitter depletion layer charging time) = re (Cbc + Ceb), τb (base transit time) = Wb^{²}/ηD, τc (collector depletion layer transit time) = Wc/2Vs, τcc (collector depletion layer charging time) = (Ree + Rc) Cbc, Rb: base resistance,
Cbc: base-collector capacitance, Ceb: base-emitter capacitance, Wb: base layer thickness, Db: base diffusion coefficient, Wc: collector depletion layer thickness, Vs: collector saturation velocity, re: emitter resistance, Ree: emitter-contact resistance, and Rc: collector resistance.

In the BT, as clear from the formulae above, to increase f_{T} and fm, it is necessary to decrease capacitances of Cbc and Ceb, thickness of base layer, base resistance, emitter resistance, and collector resistance. In particular, to obtain a larger fm, it is required to reduce Rb and Cbc. For these purposes, it is extremely important to reduce the size of each part of BT, optimize the electrode layout, and optimize the process to lower the contact resistance of electrodes, and various attempts are made in these directions.

In the heterojunction bipolar transistor (HBT) using a semiconductor material larger in band gap than the base as the emitter, leak of holes from the base to emitter is restricted (in the case of npn), and it is possible to make the base at high dope, and the emitter and collector at low dope, contrary to an ordinary BT. And it is intrinsically advantageous for reduction of base resistance Rb. Furthermore, in an ordinary BT, Cbc and Ceb are expressed by the product of factors due to doping of junction capacitance and the junction area. In the HBT, since the emitter and collector are at low dope and the base is at high dope, the factors due to doping depend only on the doping of emitter and collector, and Ceb and Ebc are expressed as follows.

$\text{Ceb α √} \overline{\text{ne}} \text{· Aeb, Cbc α √} \overline{\text{nc}} \text{· Abc}$

where ne and nc are doping concentrations of emitter and collector, and Aeb and Abc are junction areas of emitter and base, and base and collector, respectively. Therefore, in the HBT, as compared with an ordinary BT, ne and nc can be reduced, so that Ceb and Cbc can be intrinsically reduced. For the high speed operation of HBT, aside from optimization of heterostructure, optimization of device structure and process is important, as mentioned in relation to the BT. In this regard, the following methods have been attempted to reduce Ceb and Cbc. Not only in HBT but also in an ordinary BT, both normal type with the emitter disposed at the upper side and inverted type with the collector disposed at the upper side are possible (H. Kroemer, "Heterostructure Bipolar Transistors and Integrated Circuits," Proc. IEEE, vol. 70, p. 13, 1982). The normal type is advantageous for reducing the emitter size and decreasing Ceb. At the same time, it is possible to decrease Cbc by forming an insulating region in the layer of forming collector by ion implantation from above, and forming a small-size collector of buried type.

In the inverted type BT, since the collector is at the upper side, it is intrinsically advantageous for reducing the collector size and decreasing Cbc. Furthermore, by simultaneous use of ion implantation, it is possible to decrease Ceb by introducing impurities into the layer of forming emitter to form an insulating region, and reducing the emitter size.

Such attempt is made in a normal type HBT (P.M. Asbeck et al., "GaAs/(Ga, Al)As Heterojunction Bipolar Transistors with Buried Oxygen-Implanted Isolation Layers, "Electron Device, Lett., vol. EDL-5, p. 310, 1984).

To reduce the base resistance, attempts are made into a method of reducing the sheet resistance by forming a thick external base region by secondarily introducing the impurities for doping the base in order to lower the external base resistance which occupies a large portion of base resistance (P.M. Asbeck et al., "Application of Thermal Pulse Annealing to Ion-Implanted GaAlAs/GaAs Heterojunction Bipolar Transistors," IEEE Electron Device Lett., vol. EDL-4, P.81, 1983), and into a method of forming the base electrode adjacently to the emitter portion by self-alignment (Nagata et al., "A New Self-aligned Structure AlGaAs/GaAs HBT for High Speed Digital Circuits," Proc. Symp. on GaAs and Related Compounds (Inst. Phys. Conf. Serv. 79), p. 589, 1985).

In the paper "Heterojunction Bipolar Transistols" by Harris et al (Japanese Journal of applied Physics, 22, Supplements 22-1, pages 375-380 [1983]) a bipolar transistor structure is described for application to high speed digital integrated circuits. The described structure has the features of the multilayer structure mentioned in the pre-characterising clause of claim 1.

The following problems were involved in conventional methods of making bipolar transistors for high-speed applications. To form a small-sized collector of buried type by ion implantation, a small mask is additionally required. In this case, when the transistor size is smaller, mask matching for formation of this portion and the emitter region is more difficult. Or to form the emitter portion, emitter electrode, and emitter draw-out electrode by different masks presented a problem in mask matching when the transistor size was reduced. In the forming the draw-out electrode, since the emitter, base and collector portions are formed in a mesa pattern, step breakage of draw-out electrode occurred. Besides, when forming an external base portion by ion implantation or by doping at high dose, it is necessary to use different masks for covering the emitter region, and aside from the mask matching of the above portions, mask matching for forming the base electrode and base draw-out electrode became more difficult when the transistor size was smaller. Yet, since it is hard by an ordinary method to form the base electrode adjacently to the emitter, the self-alignment method may be employed, but in the conventional methods mentioned above, since the base electrode was formed before the emitter electrode, if there was limitation in the types of base electrode to be used due to the difference in alloying treatment temperature of these electrodes, mask matching for forming base draw-out electrode and mask matching for forming emitter draw-out electrode were needed, and the process became difficult when the size is reduced, and because of the mesa pattern, step breakage of draw-out electrode and wire disconnection were likely to occur.

### SUMMARY OF THE INVENTION

It is hence a primary object of this invention, relating to a bipolar transistor (BT) of normal type having the emitter at the upper side and of inverted type having the collector at the upper side, to present a first novel method of producing a BT by forming an emitter (a collector, in the case of inverted type), an emitter (a collector, in the case of inverted type) electrode, a low resistance external base by introduction of impurities, a buried type collector (emitter, in the case of inverted type) by introduction of impurities, and a base electrode positioned at an extremely close distance to the emitter, by self-alignment, using a single mask for forming the emitter (collector, in the case of inverted type).

It is another object of this invention to present a second novel method of producing a BT by forming an emitter (a collector, in inverted type), an emitter (a collector, in inverted type) electrode, an emitter (a collector, in inverted type) draw-out electrode, a low resistance external base by introduction of impurities, a buried type collector (emitter, in inverted type) by introduction of impurities, a base electrode positioned at an extremely close distance to the emitter, and a base draw-out electrode, by self-alignment, using a single mask for forming the emitter (the collector, in inverted type).

To achieve the above objects, more practically, the following method of application is applied to the BT of this invention.

According to the present invention there is provided a method of producing a bipolar transistor comprising the steps of:
forming a multilayer structural material by forming at least a second layer of semiconductor material for forming a base and a first layer and a third layer of semiconductor material possessing majority carriers different in type from majority carriers of a base region of the second layer in a sequence of the first layer, second layer and third layer on a substrate; and
processing said multilayer structural material into a bipolar transistor;
characterized in that the step of processing said multilayer structural material into a bipolar transistor comprises the steps of:
forming a dummy layer on the third layer;
forming a projection made of the material of the third layer by etching the third layer using the dummy layer as a mask; and
changing the dummy layer without changing a size of the dummy layer to an electrode metal layer having the same size as the dummy layer on the third layer;
wherein the step of changing the dummy layer to the electrode metal layer comprises the steps of;
covering the surface of the multilayer structural material and the dummy layer with a photosensitive resin:
dry etching the photosensitive resin to expose an upper surface of the dummy layer;
removing the dummy layer to form an opening in which the third layer is exposed;
evapolating an electrode metal on the exposed third layer and the photosensitive resin;
lifting off the electrode metal evapolated on the photosensitive resin; and
removing the photosensitive resin.

In one embodiment of the method, while covering the upper surface of the emitter (the collector, in inverted type) formed by said method, a base electrode layer is evaporated using the umbrella-shaped electrode layer projected on the circumference as the mask, and the base electrode layer is formed adjacently to the emitter (the collector, in inverted type).

In another embodiment of the method, side walls made of insulating thin film are disposed on the side of the emitter (collector, in inverted type) formed by said method and the periphery of the electrode layer covering the entire upper surface thereof, a base electrode metal is evaporated, the surface is coated and flattened with a photosensitive resist, and the upper surface of emitter (collector, in inverted type) is exposed by dry etching, and the base electrode metal depositing on the side wall of emitter (collector, in inverted type) portion is removed by etching, there by insulating and isolating between the emitter and base.

In a further embodiment of the method, in an intermediate process of said method, using the dummy emitter (the dummy collector, in inverted type) as mask, impurities are introduced, and a buried type collector substantially of same size as the dummy emitter (the dummy collector, in inverted type) is formed.

In a still further embodiment of the method, in an intermediate process of said method, using the dummy emitter (the dummy collector, in inverted type) as mask, impurities are introduced, and a dopant different in concentration or kind from the dopant in the base region just beneath is introduced into the external base region outside of the base region just beneath the dummy emitter (the dummy collector, in inverted type), and an external base of higher concentration or greater thickness is formed.

A yet further embodiment of the method comprises a step of insulating at least the layer to form the emitter and the layer to form the base, or at most, these layers and the layer to form the collector, on the outside of the base region, by introducing impurities from above onto a multilayer structural material, a step of forming an extension type dummy emitter (dummy collector, in inverted type) having a structure extended in conjunction with the insulating region formed by transforming from the semiconductor material of the emitter (the collector, in inverted type) to the emitter (the collector, in inverted type), a step of forming a projection coupling from the emitter (the collector, in inverted type) portion to the insulating region formed by transforming from the semiconductor material of the emitter (the collector, in inverted type), by exposing the external base region by etching, using the extension type dummy emitter (dummy collector, in inverted type) as a mask, and a step of inverting the extension type dummy emitter (dummy collector, in inverted type) into an emitter (a collector, in inverted type) electrode metal layer.

In other embodiments of the method, using the extension type emitter (collector, in inverted type) projection formed by the last described embodiment of the method and the emitter (collector, in inverted type) electrode metal layer to cover its whole upper surface, a base electrode metal layer positioned extending from the external base region adjacent to the emitter (the collector, in inverted type) to the peripheral insulating region is formed by applying the one and another embodiments described above.

### BRIEF DESCRIPTION OF THE DRAWINGS

Fig. 1 shows an example of structure of a bipolar transistor made by a method of this invention, in which (a) is a front sectional view, (b) is a side sectional view, and (c) is a layout plan of parts;
Fig. 2 is a sectional view showing the relation of the emitter electrode metal layer and a thick external base region formed by self-alignment of a bipolar transistor by the method of this invention;
Figs. 3, 4, 5 are sectional views showing the configuration of emitter electrode metal layer, emitter portion and base electrode metal layer of a bipolar transistor made by the method of this invention;

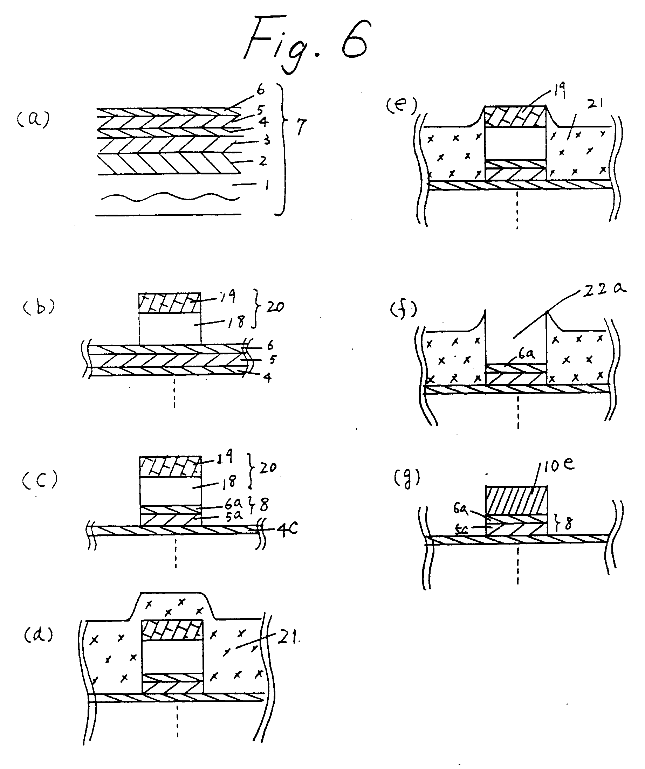

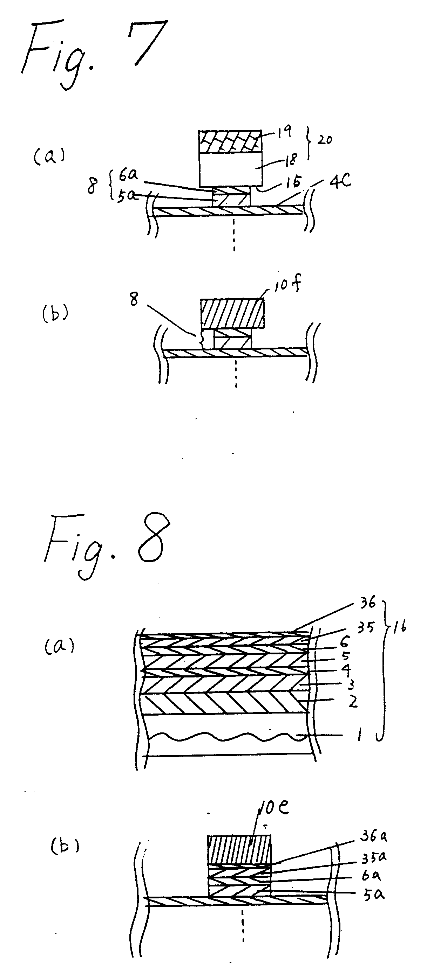

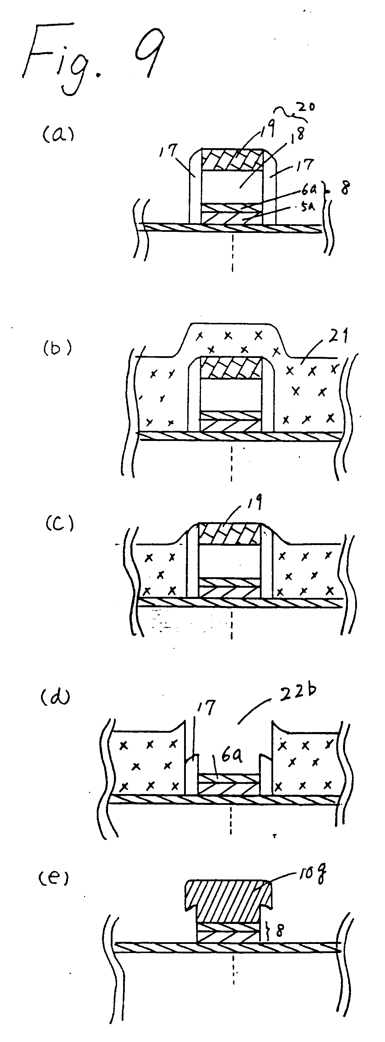

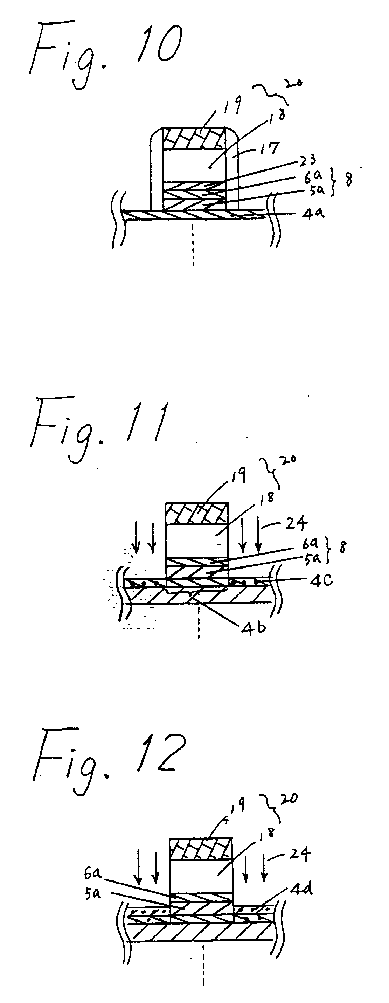

Figs. 6, 7, 8, 9, 10 are sectional view indicating the method of forming the emitter electrode metal layer by inverting from dummy emitter, in which Fig. 6 relates to a case of covering the entire upper surface of emitter, with the emitter electrode metal layer substantially same in size as the emitter, Fig. 7 shows the emitter electrode metal layer covering the upper surface of the emitter in a form of an umbrella, Fig. 8 refers to a case of placing a semiconductor material layer greater in the work function than the electrode metal, between the emitter electrode metal layer and emitter in Fig. 6, Fig. 9 denotes a case of placing the emitter electrode metal layer on the emitter to cover its upper surface in a mushroom shape, and Fig. 10 shows a case of using AlₓGa₁₋ₓAS (x = 0.4) as protective film of emitter-contact layer in the process in Fig. 9;
Fig. 11, 12 are sectional views showing the method of forming a low resistance external base region using dummy emitter and mask, by self-alignment, by ion implantation, in which Fig. 11 shows a case of forming a high dope external base region and Fig. 12 refers to a case of forming a thick external base region;
Fig. 13 denotes a method of forming a buried type collector region, by self-alignment, by ion implantation, using dummy emitter as mask;
Fig. 14 shows a method of forming, by self-alignment, a buried type collector region by ion implantation, using emitter electrode metal layer as mask;

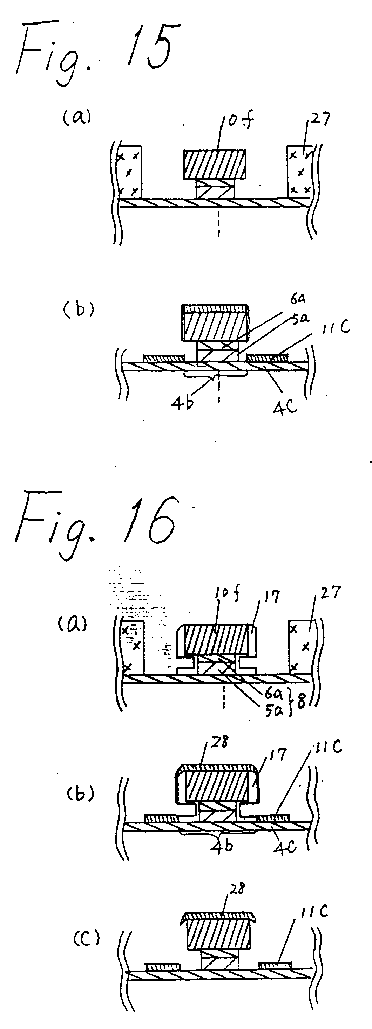

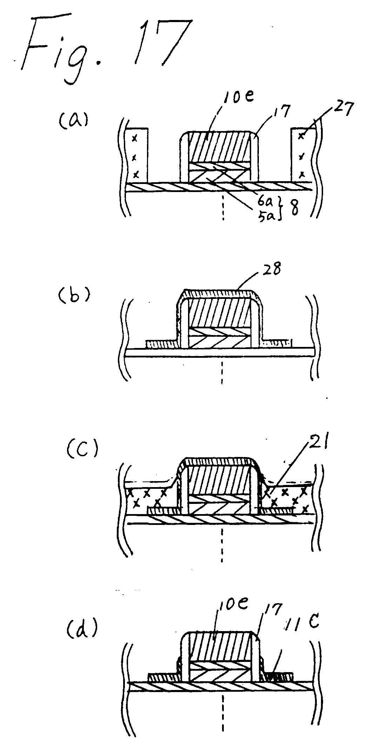

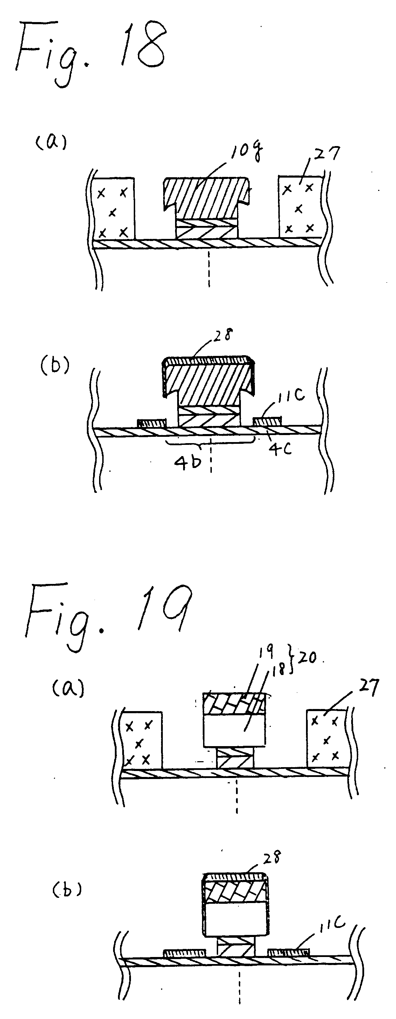

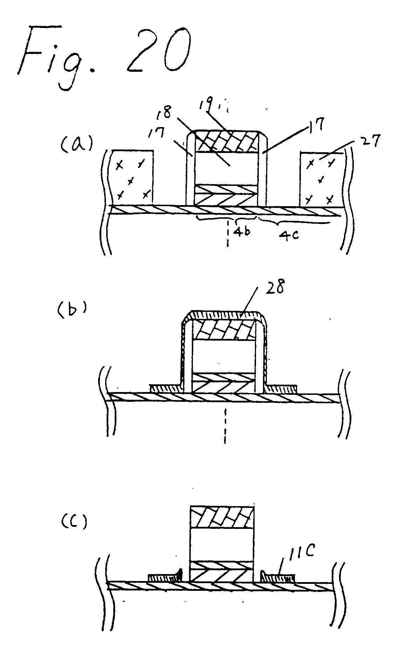

Figs. 15, 16, 17, 18, 19, 20 represent methods of forming base electrode metal layer, by using emitter electrode metal layer or dummy emitter, by self-alignment, adjacently to the emitter portion, in which Fig. 15 is a method of using an umbrella-shaped emitter electrode metal layer as mask, Fig. 16 is a method of using emitter electrode metal layer and SiOₓ side wall formed at its side as mask, Fig. 17 is a method of using SiOₓ side wall by using an emitter electrode metal layer covering the upper surface of emitter portion in the same size, Fig. 18 is a method of using a mushroom-shaped emitter electrode metal layer, Fig. 19 is a method of forming emitter electrode metal layer after forming, by self-alignment, a base electrode layer using umbrella-shaped dummy emitter, and Fig. 20 is a method of forming an emitter electrode metal layer after forming a base electrode metal layer by self-alignment, using a dummy emitter substantially of the same size as the emitter;
Fig. 21 shows a self-alignment forming method of a coupled projection of emitter region and an insulating region formed by transforming from the emitter material, and an emitter electrode metal layer to cover the entire surface of the top of this projection; and
Fig. 22 shows a forming method of base electrode metal layer positioned adjacently to the emitter portion, extending from the outer base region to the insulating region around the transistor, by using the emitter electrode metal layer in Fig. 21.

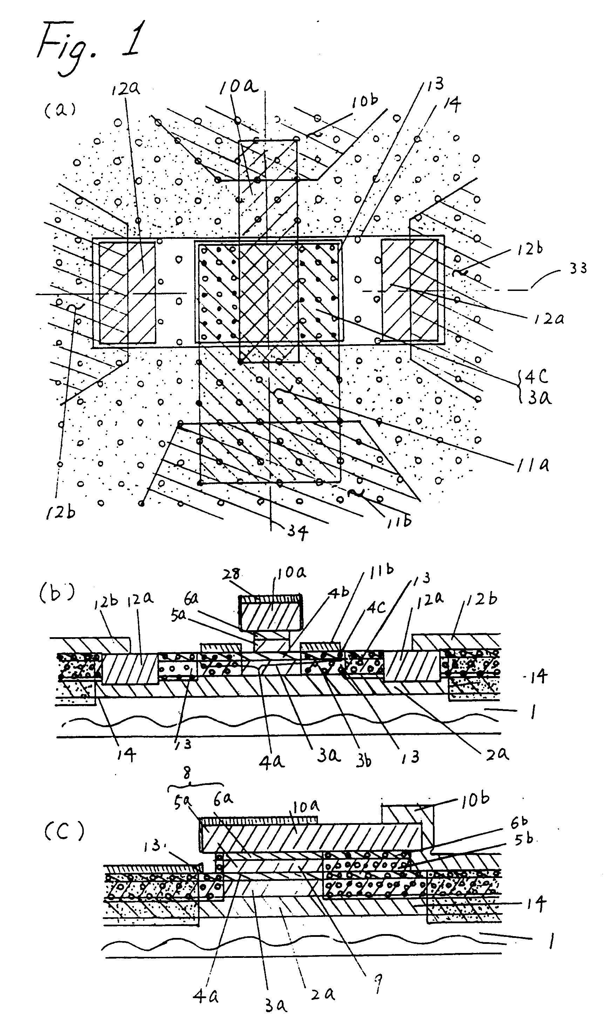

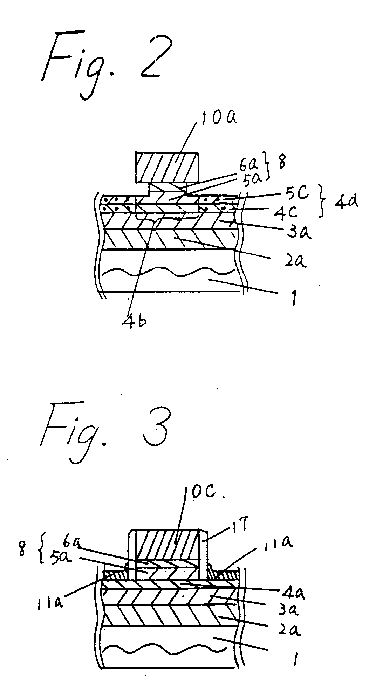

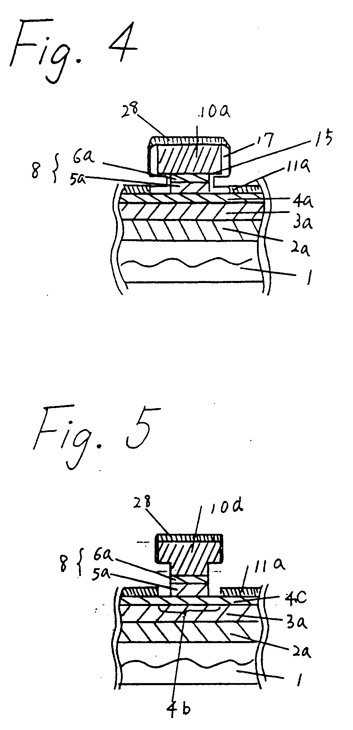

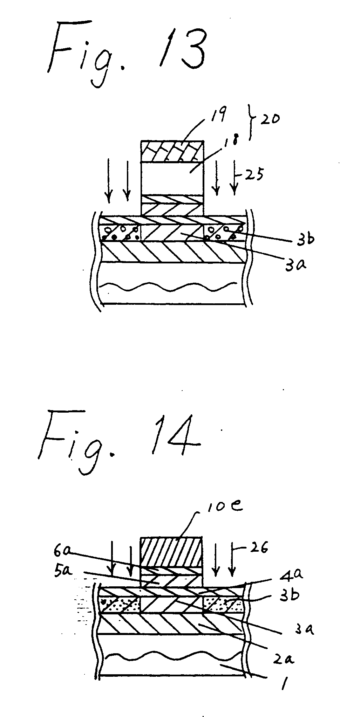

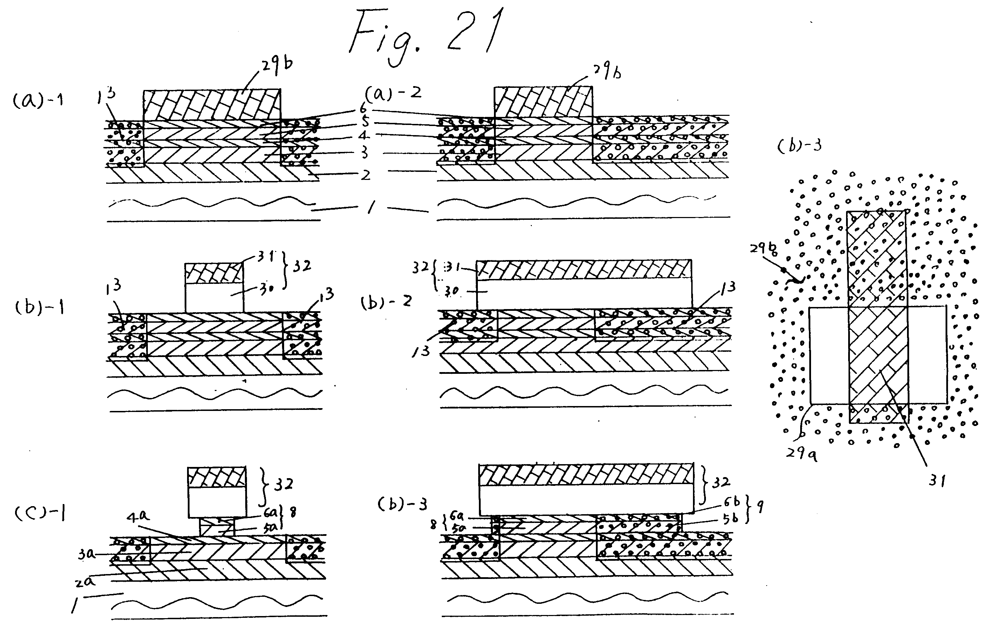

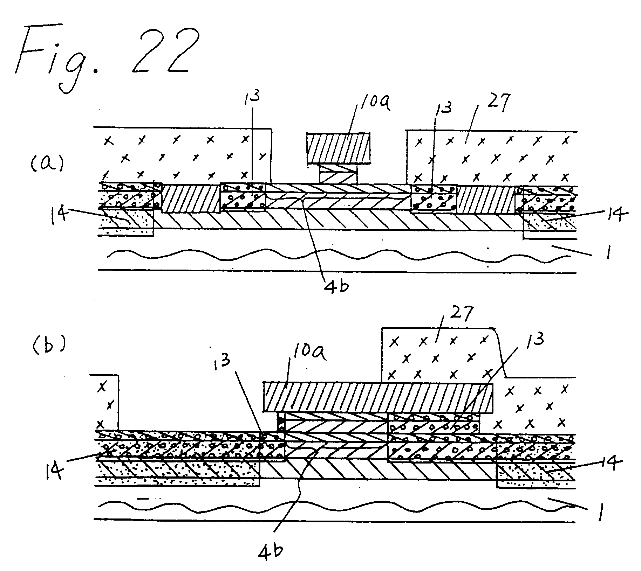

In Figs. 1 to 22, the reference numbers are meant as follows:
1--semi-insulating GaAs substrate, 2--high dope n-type GaAs, 2a--part of 2 to compose a bipolar transistor, 3--n-type GaAs, 3a--collector region, 3b--insulation region formed by transforming from material of 3, 4--high dope p-type GaAs, 4a--part of 4 to compose a bipolar transistor, 4b--base region just beneath emitter electrode metal layer or the layer composed of it and side wall, 4c--base region of outside of 4b, 4d--thick outer base region, 5--n-type AlₓGA₁₋ₓAs, 5a--part of 5 to compose a bipolar transistor, 5b--insulating region formed by transforming from the material of 5, 5c--p-type region formed by transforming from the material of 5, 6--high dope n-type GaAs, 6a--part of 6 to compose a bipolar transistor, 6b--insulating region formed by transforming from the material of 6, 7--multilayer structural material composed of parts 1 to 7, 8--emitter region composed of 5a and 6a, 9--projection composed of 8 and 5b, 6b, 10a--emitter electrode metal layer covering the whole upper surface of projection 9 in a form of umbrella, 10b--wiring pattern of emitter electrode, 10c--emitter electrode metal layer covering the whole upper surface of projection 9, having substantially same size as projection 9, 10d--mushroom-shaped emitter electrode metal layer to cover the upper surface of projection 9, 10e--emitter electrode metal layer covering the whole upper surface of emitter, having substantially same size as emitter, 10f--emitter electrode metal layer to cover the whole upper surface of emitter in a form of umbrella, 10g--mushroom-shaped emitter electrode metal layer to cover the whole upper surface of emitter, 11a--base electrode metal layer extending from outer base region to peripheral insulating region, 11b--base electrode wiring pattern, 11c--base electrode formed adjacently to emitter portion, 12a--collector electrode, 12b--collector electrode wiring pattern, 13--insulating region inside transistor, 14--external insulating region externally contacting with transistor, 15--undercut portion by etching, 16--multilayer structural material composed of 7, 35 and 36, 17--side wall, 18--SiOₓ dummy emitter, 19--Al dummy emitter, 20--dummy emitter, 21--photosensitive resin, 22a--opening with exposed 6a, 22b--umbrella-shaped opening with exposed 6b, 23--AlₓGa₁₋ₓAs (x ≧ 0.4) to protect layer 6, 24--ion implantation (Be⁺), 25--ion implantation (O⁺), 26--ion implantation (H⁺), 27--mask of photosensitive resin, 28--base electrode metal, 29a--base region, 29b--mask in same size as base region, 30--SiOₓ dummy emitter extending from emitter region to insulating region, 31--Al dummy emitter to cover the whole upper surface of 30, 32--dummy emitter composed of 30 and 31, 33--cross section of bipolar transistor, 34--cross section of bipolar transistor, 35--n-type InₓGa₁₋ₓAs (x = 0 to 1), 35a--part of 35 formed on emitter portion 8, 36--n-type InAs layer, and 36--part of 36 formed on emitter 8.
Embodiment 1. Fig. 1 shows an npn type heterojunction bipolar transistor (HBT), as an example of structure of bipolar transistor (BT) made by a first embodiment of the method of this invention. Fig. 1 (a) is a conceptual drawing showing a plan view of the configuration of components of HBT, and Fig. 1 (b) is a sectional view cutting Fig. 1 (a) on a plane 33 perpendicular to the paper surface, while Fig. 1 (c) is a sectional view cutting Fig. 1 (a) on a plane 34 perpendicular to the paper surface.
   On the circumference of base region 4a composed of high dope p-type GaAs (p⁺-GaAs), there are insulating region 13 formed by transforming from the p⁺-GaAs and GaAs (n-GaAs) doped in n-type to form collector region 3a, and insulating region 14 formed by transforming from high dope n-type GaAs (n⁺-GaAs) layer to form the contact for collector 2a in addition to semiconductor materials of 4a and 3a.
   The emitter region 8 is composed of part 5a made of n-type AlₓGa₁₋ₓAs (n-AlGaAs) with a large band gap, and part 6a made of n⁺-GaAs, and forms the portion of projection 9 coupled with an insulating region composed of 6b and 5b formed by transforming from the semiconductor materials of 6a and 5a.
   The emitter electrode metal layer 10a covers the whole upper surface of said projection 9, and has a structure of projecting like an umbrella around the projection 9, and this structure serves both as emitter electrode and as emitter draw-out electrode.
   Accordingly, the resistance of emitter contact is extremely small as compared with that of the conventional HBT. Besides, the wiring pattern 10b can be formed very easily by using a simple mask, and this wiring pattern 10b is also free from wire disconnection due to step breakage, which was a conventional problem, because it contacts with the emitter electrode metal layer 10a on three sides. Moreover, since the emitter electrode metal layer 10a serves both as emitter electrode and as emitter draw-out electrode, the HBT of an extremely small emitter size may be easily fabricated. Part 6b of projection 9 is insulated in this embodiment, but it is not necessarily required. If the part 6b is left in a state of n⁺-GaAs, the capacitance in the insulating region 14 enclosed between electrode metal layer 10a and n⁺-GaAs layer 2 is slightly increased, but this change is negligibly small in an HBT of small size. To the contrary, since the forming area of contact of emitter is widened, it is effective to reduce the contact resistance. Similarly, as for part 5b, the upper surface may be also in n-type state.
   The base electrode metal layer 11a is coupled with the base region 4b just beneath the umbrella-shaped emitter electrode metal layer 10a, and is extended from the external base region 4c to peripheral insulating region 14, working both as base electrode and as base draw-out electrode. Accordingly, formation of base wiring pattern is extremely easy, and since there is no step difference, wire disconnection due to step breakage does not occur. Incidentally, since the electrode layer 11a is formed very closely to the emitter part 5a, the external base resistance is extremely reduced.
   Just beneath the emitter electrode metal layer 10a, a buried type collector 3a substantially of a same size as the emitter electrode portion is formed, together with an insulating region 3b formed by transforming from the same semiconductor material as 3a, on its periphery. Hence, the base-collector junction capacitance Cbc can be extremely decreased.
   The base region 4c outside of the base region 4b just beneath the emitter electrode is of p-type with higher dope than the base region 4b. Accordingly, the external base region possesses a small sheet resistance.
   In this embodiment, the HBT comprehensively possessing the features of the parts mentioned above is formed.
   In said structure of HBT, AlₓGa₁₋ₓAs is used as emitter, and GaAs is used to form other parts, but the same structure may be also applicable to HBT made of other materials, or usual homojunction BT composed of emitter, base and collector of same semiconductor material, or pnp type BT. Moreover, it may be also applied to inverted type HBT or BT in which the positions of emitter and collector are exchanged so that the collector comes to the upper side.
   In Fig. 1, the structure of HBT comprises all of said emitter, emitter electrode metal layer, base electrode metal layer, buried type collector, and low resistance external base, but this is not limitative. For example, the HBT of enhanced performance as compared with the conventional product may be presented by using characteristic projection 9 and emitter electrode metal layer 10a and forming the other parts in the ordinary HBT construction, or by combining it with other characteristic structure mentioned above.
Embodiment 2. Fig. 2 shows a different structure of the first embodiment, wherein the base region 4d outside of the base region 4b just beneath the emitter electrode metal layer 10a is a thick external base region composed of p-type region 5c formed by transforming from the same semiconductor material as emitter region 5a and external base region 4c of p⁺-GaAs.
   As a result, the sheet resistance of external base may be reduced. It does not matter at all if the external base region extends to the portion of collector layer 3a, and it is contrarily effective to lower the sheet resistance of external base.
Embodiment 3. Fig. 3 shows another structure of emitter electrode metal layer 10a and base electrode metal layer 11a in the first embodiment.
   In Fig. 3, relating to the first embodiment, the whole upper surface of emitter projection 9 is covered by the emitter electrode metal layer 10a of substantially same size therewith, a side wall 17 made of Si0ₓ thin film of 300nm (3000Å) in thickness is formed on the sides around the projection 9 and emitter electrode metal layer 10a, and an electrode metal layer 11a is formed substantially in contact with the side wall 17, extending from the external base to the peripheral insulating region. The effect is same as mentioned in the first embodiment. As the side wall, meanwhile, other insulating material may be used, such as SiN_{x.}
Embodiment 4. Fig. 4 shows a further different composition of the first embodiment, in which a side wall 17 made of thin film of Si0ₓ in 300nm (3000Å) in thickness is formed on the side of emitter projection 9 and emitter electrode metal layer 10a, and an electrode metal layer 11a is formed substantially in contact with the side wall 17, extending from the external base to the peripheral insulating region 14. As the side wall, other insulating material such as SiNₓ may be also used.
Embodiment 5. Fig. 5, also relating to the first embodiment, shows a structure in which the whole upper surface of projection 9 is covered with emitter electrode metal layer, and the electrode metal layer itself is shaped like a mushroom, spreading to the peripheral parts of the projection 9, and in connection with the base region 4b just beneath the mushroom electrode, there is a base electrode metal layer 11a extending from the external base region 4c to the peripheral insulating region 14.
Embodiment 6. Fig. 6 illustrates a method of fabrication by forming an emitter electrode metal layer 10e to cover the whole upper surface of projection 8 composed of emitter region. As shown in Fig. 6 (a), on a semi-insulating GaAs substrate 1, a multilayer structural material 7 composed of n⁺-GaAs layer 2, n-GaAs layer 3, p⁺-GaAs layer 4, n-AlGaAs layer 5, and n⁺-GaAs layer 6 is formed by epitaxial growth.
   On this multilayer structural material 7, a 1 µm thick Si0ₓ thin film is formed, and in the portion corresponding to emitter on this film, an Al layer 19 of 500nm (5OOOÅ) in thickness is formed by evaporating and lifting off, and Si0ₓ layer 18 corresponding to emitter portion is formed by dry etching with CHF₃, using the Al layer 19 as mask (Fig. 6 [b]). By exposing the external base region 4c by etching, using a dummy emitter 20 composed of Si0ₓ layer 18 and Al layer 19 as mask, and a protruding emitter region 8 is formed (Fig. 6 [c]). In succession, the surface is covered and flattened with photosensitive resin 21 (Fig. 6 [d]), and the photosensitive resin 21 is etched by dry etching using oxygen plasma, and the upper part of dummy emitter 20 is exposed (Fig. 6 [e]), then, removing the Al layer 19 by hydrochloric acid and also removing Si0ₓ 18 by buffer HF, an opening 22a is formed (Fig. 6 [f]). Next, in this opening 22a, AuGe, Ni, Ti and Au are evaporated in this order and lifted off, and an emitter electrode metal layer 10e is formed (Fig. 6 (g)). As a result, the emitter electrode metal layer 10e to cover the whole upper surface of emitter region 8 is formed. In this embodiment, meanwhile, as the layer to form dummy emitter, Si0ₓ layer and Al layer are used, but instead of Si0ₓ, other materials such as SiNₓ may be also used. Or, instead of Al, other metal may be used, too. Incidentally, after forming Si0ₓ 18 by dry etching, the Al layer 19 is not necessarily required. In this embodiment, the external base region 4c can be made also by etching until close to the external base region using a dummy emitter 20 as a mask, and then by etching up to the external base region using the emitter electrode metal layer as a mask. This has an effect to protect the external base region from being damaged during the process. This process can be applied also to homojunction BT, or HBT or BT of inverted type.
Embodiment 7. Fig. 7, relating to the embodiment of Fig. 6, shows a different structure, in which, after forming dummy emitter 20 as in Fig. 6 (b), wet etching is carried out to expose the external base region 4c as shown in Fig. 7 (a), and an undercut portion 15 is formed beneath the dummy emitter 20 by etching (Fig. 7 (a)), and thereafter, using the process of (d) through (g) in Fig. 6, an emitter electrode metal layer 1Of to cover the emitter projection 8 in a form of umbrella as shown in fig. 7 (b) is formed, using dummy emitter 20.
Embodiment 8. By forming a multilayer structural material 16 by epitaxial growth of high dope n-type InₓGa₁₋ₓAs layer 35 in which x carries continuously from 0 to 1 (n-InₓGa₁₋ₓAs (x = 0 to 1) and high dope n-type InAs layer 36 on multilayer structure material 7, an emitter electrode metal layer 10e is formed as shown in Fig. 8 (b) by applying the method of the embodiment of Fig. 6. Since the work function of InAs is greater than that of electrode metal, a low resistance emitter contact may be obtained without any alloying heat treatment. In the embodiment, InₓGa₁₋ₓAs continuously varying in composition and InAs are formed in layers, but InₓGa₁₋ₓAs of a specific composition may be also formed in a layer.
Embodiment 9. Fig. 9 shows a fabricating method of mushroom-shaped emitter electrode metal layer 1Og. After forming an emitter projection 8 by etching as shown in Fig. 6 (c), using dummy emitter 20 as mask, the surface is covered with a thin film of Si0ₓ of 300nm (3000A) in thickness, and a side wall 17 composed of Si0ₓ is formed on the sides of emitter projection 8 and dummy emitter 20 by anisotropic dry etching using CHF₃ (Fig. 9 (a)). Then the surface is coated and flattened with a photosensitive resin 21 (Fig. 9 (b)), and the upper part of the dummy emitter 20 is exposed by dry etching using oxygen plasma (Fig. 9 (c)), and after removing Al 19 by HCl, an opening 22b with n⁺-GaAs layer 6a exposed is formed by anisotropic dry etching using CHF₃ (Fig. 9 (d)). In succession, AuGe, Ni, Ti and Au are evaporated in this order and lifted off, thereby forming an emitter electrode metal layer 10g.
Embodiment 10. By forming an AlₓGa₁₋ₓAs layer 23 where x is 0.4 or more on the multilayer structural material in Fig. 6 (a), the process of the embodiment of Fig. 9 is applied thereafter. However, in the process of Fig. 9 (d), after removing SiOₓ layer 18 and also removing AlₓGa₁₋ₓAs layer 23 by using acid, the emitter electrode metal layer 10g is formed. By this method, damage of n⁺-GaAs layer 6a by dry etching may be prevented, and a clean n⁺-GaAs layer 6a appears, so that an ohmic contact of high quality may be obtained. This method may be also applied in the embodiments of Figs. 6 to 8.
Embodiment 11. Fig. 11 shows a method of forming an external base region 4c of high dope p-type, by ion implantation of p-type dopant into the external base region 4c outside of the base region 4b just beneath the emitter electrode, using dummy emitter as mask. After forming the structure of (c) in Fig. 6, Be⁺ is implanted using the dummy emitter 20 as mask (24), and it is heated to 750°C for 10 seconds, so that a high dose external base region 4c as shown in Fig. 11 is formed. Thereafter, applying the method of the embodiment shown in Fig. 6, the dummy emitter 20 is inverted to an emitter electrode metal layer 10e.
   After ion implantation, it is necessary to anneal at a relatively high temperature, but adverse effects are not present because the n⁺-GaAs layer 6 is covered with SiOₓ layer 18. Otherwise, Be⁺ may be implanted at the step of Fig. 6 (b), or after etching until close to the external base region 4c, and then the external base may be exposed by etching. Or the implanted Be⁺ may penetrate even into the collector region 3a. For this purpose, aside from Be⁺, Mg⁺ or Zn⁺ may be also used.
Embodiment 12. As shown in Fig. 12, after forming a dummy emitter 20 as in Fig. 6 (b), Be⁺ is implanted, and part of GaAs layer 6 and AlₓGa₁₋ₓAs layer 5 is etched off, and a thick external base region 4d is formed, so that the sheet resistance may be lowered. Thereafter, by applying the method shown in Fig. 6, the dummy emitter 20 is changed into an emitter electrode metal layer 10e.
Embodiment 13. Fig. 13 shows a method of forming a buried type collector 3a of the same size as dummy emitter by ion implantation, using the dummy emitter 20 as mask. After the step in Fig. 6 (c), a collector 3 substantially of same size as dummy emitter 20 and its peripheral insulating region 3b are formed by implanting O⁺ ions into the layer 3 in which the collector is to be formed using the dummy emitter as mask as shown in Fig. 13, and, by heat treatment at 750°C for 10 seconds. Thereafter, by employing the method shown in Fig. 6, the dummy emitter 20 is inverted into an emitter electrode metal layer 10e. Aside from O⁺, other ions such as B+ may be used. Same as in the embodiments of Figs. 11 and 12, heat treatment at high temperature is enabled owing to the existence of SiOₓ dummy emitter.
Embodiment 14. After forming an emitter electrode metal layer 10e (Fig. 6 (g)), the collector region 3a substantially of same size as the emitter electrode metal layer and its peripheral insulating region 3b are formed by implanting H⁺ ions are implanted into a layer 3 for forming a collector, as shown in Fig. 14, using the emitter electrode metal layer 10e as mask. In the case of H⁺ ion implantation, since heat treatment is not needed in formation of insulating region, the contact part formed between the emitter electrode metal layer 10e and emitter is protected from damage. Hence, it is possible to form a buried type collector region 3a by using H⁺.
Embodiment 15. After forming an umbrella-shaped emitter electrode metal layer 10f as shown in Fig. 7 (b), a base electrode metal 28 is evaporated and lifted off, using photosensitive resion 27 and electrode metal layer 10f as mask as shown in Fig. 15 (a), and the base electrode metal layer 11c is coupled with the base region 4b just beneath the electrode metal layer 10a, thereby forming a base electrode 11c in the external base region 4c. As a result, the base electrode 11c is formed by self-alignment at an extremely close distance from the emitter 5a, and the base resistance may be notably reduced.
Embodiment 16. After forming an umbrella-shaped emitter electrode metal layer 10f as shown in Fig. 7 (b), the surface is coated with a thin film of SiOₓ in a thickness of 300nm (3000Å), and by anisotropic dry etching using CHF₃, SiOₓ side wall 17 is formed on the sides around emitter projection 8 and electrode metal layer 10f as shown in Fig. 16 (a). Furthermore, as shown in Fig. 16 (b), a base electrode metal 28 is evaporated and lifted off by using photosensitive resion 27 and umbrella-shaped portion composed of electrode metal layer 10f and side wall 17 as mask. This forms the base electrode metal layer 11c in the external base region 4c, coupled with the base region 4b just beneath the electrode metal layer 10f and side wall 17, as shown in Fig. 16 (b). Then the SiOₓ side wall 17 is removed by buffer HF. As a result, even if the base electrode metal 28 deposits on the side of metal 28, shorting is prevented, and hence the reliability of process is remarkably improved. Hence, the same effect as in the embodiment of Fig. 15 is obtained.
Embodiment 17. After forming an emitter electrode metal layer 10e (Fig. 6 (g)), SiOₓ side wall 17 is formed on the sides around emitter projection 8 and metal layer 10e, and a mask 27 of photosensitive resin is applied as shown in Fig. 17 (a). In succession, base electrode metal 28 is evaporated and lifted off, and a structure shown in Fig. 17 (b) is formed. Then, the surface is covered with photosensitive resist 21, and the upper surface of electrode metal layer 10e is exposed by dry etching using oxygen plasma as shown in Fig. 17 (c). By etching away the metal 28 depositing on the side wall 17, the emitter electrode and base electrode are separated. As a result, as a shown in Fig. 17 (d), the base electrode metal layer 11c is formed at a distance of the width of side wall 17 with respect to emitter part 5a. Hence, the external base resistance may be reduced.
Embodiment 18. After forming a mushroom-shaped emitter electrode metal layer 10g as shown in Fig. 9 (e), a mask 27 of photosensitive resin is formed as shown in Fig. 18 (a), and a base electrode metal 28 is evaporated and lifted off by using this mask 27 and also metal electrode layer 10g as mask. Consequently, a base electrode metal layer 11c is formed on the external base region 4c in conjunction with the base region 4b just beneath the electrode metal layer 10g. As a result, the external base resistance can be reduced.
Embodiment 19. In succession to Fig. 7 (a), a base electrode metal 28 is evaporated and lifted off by using photosensitive resion 27 and dummy emitter 20 as mask as shown in Fig. 19 (a). Consequently, a base electrode metal layer 11c is formed as shown in Fig. 11 (b). Next, using the process of changing the dummy emitter 20 into emitter electrode metal layer shown in embodiment 6, a structure corresponding to Fig. 15 (b) is formed. As a result, the base electrode metal layer 11c is formed adjacently to the emitter 5a, and the base resistance may be lowered. In this method, incidentally, since the base electrode is formed first, it is important that the contact between the base electrode metal and external base is free from damage at the forming temperature of ohmic contact of emitter. In this embodiment, as the material for base electrode metal, for example, Cr/Au and Cr/AuZn/Au may be used.
Embodiment 20. In the formation of structure in Fig. 9 (a), a side wall composed of SiNₓ is formed as side wall 17, in a similar method as shown in Fig. 20 (a), and a base electrode metal 28 is evaporated and lifted off through the mask 27 of photosensitive resin as shown in Fig. 20 (b). Thereafter, applying the method of separation of base electrode from emitter electrode shown in the embodiment of Fig. 17, and selectively removing SiNₓ with respect to the dummy emitter 19, a structure of Fig. 20 (c) is formed. Then, conforming to the process of changing the dummy emitter into emitter electrode metal layer shown in the embodiment of Fig. 6, the base electrode metal layer 11c is formed adjacently to the emitter part 5a. Same as in the embodiment of Fig. 19, it is necessary to select a metal, as base electrode metal, of which ohmic contact forming temperature is not lower than the ohmic contact forming temperature of emitter. In this embodiment, the external base region 4c can be exposed also by etching until close to the region 4c before forming the side wall 17, and then by etching up to the region 4c.
Embodiment 21. Fig. 21 shows a method of forming an emitter projection shown in Fig. 1 and an electrode. metal layer 10a serving both as emitter electrode and as draw-out electrode. On the multilayer structural material 7 shown in Fig. 6, a mask 29b corresponding to the size 29a of the base is formed as shown in Fig. 21 (a), and O⁺ ions are implanted into the layer 3 for forming the collector. Consequently, an insulating region 13 is formed. Then, on the portion 29a corresponding to the base region, an extension type dummy emitter 32 composed of SiOₓ layer 30 and Al layer 31 extending from the emitter part to the insulation region 13 is formed by the method shown in the embodiment of Fig. 6 (Fig. 21 (b)). Thereafter, according to the method shown in the embodiment of Fig. 7, an extension type emitter projection 9 and an external base region 4c are formed (Fig. 21 (c)), and an umbrella-shaped dummy emitter 32 is converted into an emitter electrode metal layer 10a. By employing this method, since the emitter electrode serves also as emitter draw-out electrode and it is formed by self-alignment corresponding to the emitter part, a bipolar transistor of a very small emitter size can be also fabricated. In this embodiment, although the method of forming an umbrella-shaped electrode metal layer is exhibited, the formation of emitter electrode metal layer as disclosed in the embodiments of Figs. 6, 8, 9, 10 is also applicable.
Embodiment 22. Fig. 22 shows a method of forming, by self-alignment, a base electrode metal layer 11a serving as both base electrode and base draw-out electrode and existing adjacently to the emitter portion, referring to a case of using an umbrella-shaped electrode metal layer. In the process shown in Fig. 21, after forming an umbrella-shaped electrode metal layer 10a shown in Fig. 1, a collector electrode 12a is formed as shown in Fig. 1, and H⁺ ions are implanted around the transistor. Consequently, an insulating region 14 ranging from the surface to substrate 1 is formed. Then, as shown in Fig. 22, a base electrode 28 is evaporated and lifted off by using a photosensitive resin mask 27 and the umbrella-shaped emitter electrode metal layer 10a as mask. Consequently, in conjunction with the base region 4b just beneath the emitter electrode metal layer 10a, a base electrode metal layer 11a extending from the external base region to the peripheral insulating region 14 is formed. In this embodiment, although the method of the embodiment of Fig. 15 of using umbrella-shaped emitter electrode metal layer is employed, the method of formation of base electrode metal layer as disclosed in the embodiments of Figs. 16, 17, 18, 19, 20 is also applicable.

## Claims

1. A method of producing a bipolar transistor comprising the steps of:
forming a multilayer structural material (7) by forming at least a second layer (4) of semiconductor material for forming a base and a first layer (2,3) and a third layer (8) of semiconductor material possessing majority carriers different in type from majority carriers of a base region (4b) of the second layer in a sequence of the first layer, second layer and third layer on a substrate (1); and
processing said multilayer structural material (7) into a bipolar transistor (4a, 5a, 6a);
characterized in that the step of processing said multilayer structural material into a bipolar transistor comprises the steps of:
forming a dummy layer (20, 32) on the third layer (8);
forming a projection (9) made of the material (5) of the third layer by etching the third layer using the dummy layer as a mask; and
changing the dummy layer (20, 32) without changing a size of the dummy layer to an electrode metal layer (10a, c, d, e, f, g) having the same size as the dummy layer on the third layer;
wherein the step of changing the dummy layer (20, 32) to the electrode metal layer (10a, c, d, e, f, g) comprises the steps of:
covering the surface of the multilayer structural material (7) and the dummy layer with a photosensitive resin (21);
dry etching the photosensitive resin (21) to expose an upper surface (19) of the dummy layer;
removing the dummy layer to form an opening (22a) in which the third layer is exposed;
evaporating an electrode metal on the exposed third layer and the photosensitive resin;
lifting off the electrode metal evaporated on the photosensitive resin; and
removing the photosensitive resin.

2. A method according to claim 1, wherein the third layer (8) is etched using the dummy layer (20, 32) as a mask so that an external base region (4c) of the second layer (4) exposes in the step of forming the projection (9) made of the material (5) of the third layer, said method further comprising a step of evaporating a base electrode metal (28) on the exposed external base region (5c) using the electrode metal layer (10a, c, d, e, f, g) on the third layer as a mask to form a base electrode metal layer (11a) on the external base region (4c).

3. A method according to claim 1, wherein the third layer (8) is etched using the dummy layer (20, 32) as a mask so that an external base region (4c) of the second layer (4) exposes in the step of forming the projection (9) made of the material of the third layer (5), said method further comprising a step of forming a side wall (17) of an insulating material on a side surface of the projection (9) made of the material (5) of the third layer and a side surface of the electrode metal layer (10a, c, d, e, f, g) on the third layer, and a step of evaporating a base electrode metal (28) on the exposed external base region (5c) using the electrode metal layer on the third layer and the side wall (17) of the insulating material as a mask to form a base electrode metal layer (11a) on the external base region (4c).

4. A method according to claim 1, wherein the third layer (8) is etched using the dummy layer (20, 32) as a mask so that an external base region (4c) of the second layer (4) exposes in the step of forming the projection (9) made of the material (5) of the third layer, said method further comprising a step of forming a side wall (17) of an insulating material on a side surface of the projection (9) made of the material (5) of the third layer and a side surface of the electrode metal layer (10a, c, d, e, f, g) on the third layer, a step of evaporating a base electrode metal (28) on the whole surface, a step of covering the whole surface of the evaporated base electrode metal (11a) with a photosensitive resin (21), a step of exposing the projection (9) possessing the side wall (17) of the insulating material by etching, and a step of removing the base electrode metal (28) evaporated on the projection (9).

5. A method according to claim 1, wherein the third layer (8) is etched down to the vicinity of an external base region (4c) of the second layer (4) using the dummy layer (20, 32) as a mask in the step of forming the projection (9) made of the material (5) of the third layer, said method further comprising a step of exposing the external base region (4c) of the second layer (4) by etching using the electrode metal layer (10a, c, d, e, f, g) on the third layer as a mask, and a step of evaporating a base electrode metal (28) using the electrode metal layer on the third layer as a mask to form a base electrode metal layer (11a) on the exposed external base region (4c).

6. A method according to claim 1, wherein the third layer (8) is etched using the dummy layer (20, 32) as a mask so that an external base region (4c) of the second layer (4) exposes in the step of forming the projection (9) made of the material (5) of the third layer, said method further comprising a step of evaporating a base electrode metal (28) on the exposed external base region (5c) using the dummy layer (20, 32) as a mask to form a base electrode metal layer (11a) on the external base region (4c).

7. A method according to claim 1, wherein the third layer (8) is etched using the dummy layer (20, 32) as a mask so that an external base region (4c) of the second layer (4) exposes in the step of forming the projection (9) made of the material (5) of the third layer, said method further comprising, before the step of changing the dummy layer to the electrode metal layer (10a, c, d, e, f, g) on the third layer, a step of forming a side wall (17) of an insulating material on a side surface of the projection (9) made of the material (5) of the third layer and a side surface of the dummy layer (20, 32), a step of evaporating a base electrode metal (28) on the whole surface, a step of covering the whole surface of the evapolated base electrode metal with a photosensitive resin (21), a step of exposing the upper surface (19) of the dummy layer (20, 32) by etching, a step of removing the base electrode metal evaporated on the side wall (17) of the insulating material, and a step of removing the side wall of the insulating material.

8. A method according to claim 1, further comprising, before the step of changing the dummy layer (20, 32) to the electrode metal layer (10a, c, d, e, f, g) on the third layer (8), a step of introducing impurities (24) into the second layer (4) using the dummy layer (20, 32) as a mask to form the impurity introduced portion (4c) of the second layer into a low resistance external base region.

9. A method according to claim 1, further comprising, before the step of changing the dummy layer (20, 32) to the electrode metal layer (10a, c, d, e, f, g) on the third layer (8), a step of introducing impurities (25, 26) into the first layer (3) using the dummy layer (20, 32) as a mask to form the impurity introduced portion (3a) of the first layer (3) into an insulating layer (3b) so that an active portion of the first layer becomes substantially the same in size as the dummy layer.

10. A method according to claim 1, further comprising, after the step of changing the dummy layer (20, 32) to the electrode metal layer (10a, c, d, e, f, g) on the third layer (8), a step of introducing impurities (25, 26) into the first layer (3) using the electrode metal layer on the third layer as a mask to form the impurity introduced portion (3a) of the first layer (3) into an insulating layer (3b) so that an active portion of the first layer becomes substantially the same in size as the electrode metal layer on the third layer.

11. A method according to claim 1, further comprising, before the step of forming the dummy layer (20, 32), a step of introducing impurities (25, 26) into a peripheral part (14) of a base region (4c) of the second layer (4) to form the peripheral part (14) into an insulating layer, wherein the dummy layer (20, 32) is formed to extend from a portion above the base region (4c) to a portion above the peripheral part (14).

## Patentansprüche

1. Ein Verfahren zum Herstellen eines bipolaren Transistors, das die Schritte umfaßt:
Bilden eines Mehrschichtstrukturmaterials (7) durch Bilden von wenigstens einer zweiten Schicht (4) aus Halbleitermaterial zum Bilden einer Basis und einer ersten Schicht (2,3) und einer dritten Schicht (8) aus Halbleitermaterial, das Majoritätsträger besitzt, die von der Art der Majoritätsträger eines Basisbereiches (4b) der zweiten Schicht in einer Reihenfolge der ersten Schicht, der zweiten Schicht und der dritten Schicht auf einem Substrat (1) unterschiedlich sind; und;
Verarbeiten des genannten Mehrschichtstrukturmaterials (7) zu einem bipolaren Transistor (4a, 5a, 6a);
**dadurch gekennzeichnet,**
daß der Schritt des Verarbeitens des genannten Mehrschichtstrukturmaterials zu einem bipolaren Transistor die Schritte umfaßt:
Bilden einer Hilfsschicht (20, 32) auf der dritten Schicht (8);
Bilden eines Vorsprungs (9), der aus dem Material (5) der dritten Schicht gemacht ist, durch Ätzen der dritten Schicht, wobei die Hilfsschicht als eine Maske verwendet wird; und
Ändern der Hilfsschicht (20, 32), ohne eine Größe der Hilfsschicht zu ändern, zu einer Elektrodenmetallschicht (10a, c, d, e, f, g), die dieselbe Größe wie die Hilfsschicht auf der dritten Schicht hat;
wobei der Schritt des Änderns der Hilfsschicht (20, 32) zu der Elektrodenmetallschicht (10a, c, d, e, f, g) die Schritte umfaßt:
Bedecken der Oberfläche des Mehrschichtstrukturmaterials (7) und der Hilfsschicht mit einem photoempfindlichen Kunststoff (21);
Trockenätzen des photoempfindlichen Kunststoffes (21), um eine obere Oberfläche (19) der Hilfsschicht freizulegen;
Entfernen der Hilfsschicht, um eine Öffnung (22a) zu bilden, in der die dritte Schicht freigelegt ist;
Aufdampfen eines Elektrodenmetalls auf die freigelegte, dritte Schicht und den photoempfindlichen Kunststoff;
Abheben des auf den photoempfindlichen Kunststoff aufgedamften Elektrodenmetalls; und
Entfernen des photoempfindlichen Kunststoffes.

2. Ein Verfahren gemäß Anspruch 1, bei dem die dritte Schicht (8) unter Verwendung der Hilfsschicht (20, 32) als eine Maske so geätzt wird, daß ein äußerer Basisbereich (4c) der zweiten Schicht (4) bei dem Schritt des Bildens des Vorsprungs (9) frei wird, der aus dem Material (5) der dritten Schicht gemacht wird, wobei das genannte Verfahren ferner einen Schritt des Aufdampfens eines Basiselektrodenmetalls (28) auf den freigelegten, äußeren Basisbereich (5c) umfaßt, wobei die Elektrodenmetallschicht (10a, c, d, e, f, g) auf der dritten Schicht als eine Maske verwendet wird, eine Basiselektrodenmetallschicht (11a) auf dem äußeren Basisbereich (4c) zu bilden.

3. Ein Verfahren gemäß Anspruch 1, bei dem die dritte Schicht (8) geätzt wird, wobei die Hilfsschicht (20, 32) als eine Maske so verwendet wird, daß ein äußerer Basisbereich (4c) der zweiten Schicht (4) bei dem Schritt des Bildens des Vorsprungs (9) frei wird, der aus dem Material der dritten Schicht (5) gemacht wird, wobei das genannte Verfahren ferner einen Schritt des Bildens einer Seitenwand (17) aus einem isolierenden Material auf einer Seitenoberfläche des Vorsprungs (9), der aus dem Material (5) der dritten Schicht gemacht ist, und einer Seitenoberfläche der Elektrodenmetallschicht (10a, c, d, e, f, g) auf der dritten Schicht umfaßt, und einen Schritt des Aufdampfens eines Basiselektrodenmetalls (28) auf den freigelegten, äußeren Basisbereich (5c), wobei die Elektrodenmetallschicht auf der dritten Schicht und die Seitenwand (17) des isolierenden Material als eine Maske verwendet werden, eine Basiselektrodenmetallschicht (11a) auf dem äußeren Basisbereich (4c) zu bilden.

4. Ein Verfahren gemäß Anspruch 1, bei dem die dritte Schicht (8) geätzt wird, wobei die Hilfsschicht (20, 32) als eine Maske so verwendet wird, daß ein äußerer Basisbereich (4c) der zweiten Schicht (4) bei dem Schritt des Bildens des Vorsprungs (9) frei wird, der aus dem Material der dritten Schicht (5) gemacht wird, wobei das genannte Verfahren ferner einen Schritt des Bildens einer Seitenwand (17) aus einem isolierenden Material auf einer Seitenoberfläche des Vorsprungs (9), der aus dem Material (5) der dritten Schicht gemacht ist, und einer Seitenoberfläche der Elektrodenmetallschicht (10a, c, d, e, f, g) auf der dritten Schicht umfaßt, und einen Schritt des Aufdampfens eines Basiselektrodenmetalls (28) auf die ganzen Oberfläche, einen Schritt des Überdeckens der ganzen Oberfläche des aufgedampften Basiselektrodenmetalls (11a) mit einem photoempfindlichen Kunststoff (21), einen Schritt des Freilegens des Vorsprungs (9), der die Seitenwand (17) aus dem isolierenden Material besitzt, durch Ätzen, und einen Schritt des Entfernens des Basiselektrodenmetalls (28), das auf den Vorsprung (9) aufgedampft ist.

5. Ein Verfahren gemäß Anspruch 1, bei dem die dritte Schicht (8) bis in die Nähe eines äußeren Basisbereiches (4c) der zweiten Schicht (4) heruntergeätzt wird, wobei die Hilfsschicht (20, 32) als eine Maske bei dem Schritt des Bildens des Vorsprungs (9) verwendet wird, der aus dem Material (5) der dritten Schicht gemacht ist, wobei das genannte Verfahren ferner einen Schritt des Freilegens des äußeren Basisbereiches (4c) der zweiten Schicht (4) durch Ätzen, wobei die Elektrodenmetallschicht (10a, c, d, e, f, g) auf der dritten Schicht als eine Maske verwendet wird, und einen Schritt des Aufdampfens eines Basiselektrodenmetalls (28) umfaßt, wobei die Elektrodenmetallschicht auf der dritten Schicht als eine Maske verwendet wird, um eine Basiselektrodenmetallschicht (11a) auf dem freigelegten, äußeren Basisbereich (4c) zu bilden.

6. Ein Verfahren gemäß Anspruch 1, bei dem die dritte Schicht (8) geätzt wird, wobei die Hilfsschicht (20, 32) als eine Maske so verwendet wird, daß ein äußerer Basisbereich (4c) der zweiten Schicht (4) bei dem Schritt des Bildens des Vorsprungs (9) frei wird, der aus dem Material (5) der dritten Schicht gemacht ist, wobei das genannte Verfahren ferner einen Schritt des Aufdampfens eines Basiselektrodenmetalls (28) auf den freigelegten, äußeren Basisbereich (5c) umfaßt, wobei die Hilfsschicht (20, 32) als eine Maske verwendet wird, um eine Basiselektrodenmetallschicht (11a) auf dem äußeren Basisbereich (4c) zu bilden.

7. Ein Verfahren gemäß Anspruch 1, bei dem die dritte Schicht (8) geätzt wird, wobei die Hilfsschicht (20, 32) als eine Maske so verwendet wird, daß ein äußerer Basisbereich (4c) der zweiten Schicht (4) bei dem Schritt des Bildens des Vorsprungs (9) frei wird, der aus dem Material (5) der dritten Schicht gemacht ist, wobei das genannte Verfahren ferner umfaßt, vor dem Schritt des Änderns der Hilfsschicht zu der Elektrodenmetallschicht (10a, c, d, e, f, g) auf der dritten Schicht einen Schritt des Bildens einer Seitenwand (17) aus einem isolierenden Material auf einer Seitenoberfläche des Vorsprungs (9), der aus dem Material (5) der dritten Schicht gemacht ist, und einer Seitenoberfläche der Hilfsschicht (20, 32), einen Schritt des Aufdampfens eines Basiselektrodenmetalls (28) auf der ganzen Oberfläche, einen Schritt des Bedeckens der ganzen Oberfläche des verdampften Basiselektrodenmetalls mit einem photoempfindlichen Kunststoff (21), einen Schritt des Freilegens der oberen Oberfläche (19) der Hilfsschicht (20, 32) durch Ätzen, einen Schritt des Entfernens des Basiselektrodenmetalls, das auf die Seitenwand (17) des isolierenden Materials aufgedampft ist, und einen Schritt des Entfernens der Seitenwand des isolierenden Materials.

8. Ein Verfahren gemäß Anspruch 1, das vor dem Schritt des Änderns der Hilfsschicht (20, 32) zu der Elektrodenmetallschicht (10a, c, d, e, f, g) auf der dritten Schicht (8) einen Schritt des Einführens von Störstellen (24) in die zweite Schicht (4) umfaßt, wobei die Hilfsschicht (20, 32) als eine Maske verwendet wird, den Bereich (4c) der zweiten Schicht mit den eingeführten Störstellen zu einem äußeren Basisbereich mit niederem Widerstand zu bilden.

9. Ein Verfahren gemäß Anspruch 1, das ferner vor dem Schritt des Änderns der Hilfsschicht (20, 32) zu der Elektrodenmetallschicht (10a, c, d, e, f, g) auf der dritten Schicht (8) einen Schritt des Einführens von Verunreingungen (25, 26) in die erste Schicht (3) umfaßt, wobei die Hilfsschicht (20, 32) als eine Maske verwendet wird, den Bereich (3a) der ersten Schicht (3) mit den eingeführten Störstellen zu einer isolierenden Schicht (3b) so zu bilden, daß ein aktiver Bereich der ersten Schicht im wesentlichen dieselbe Größe wie die Hilfsschicht erhält.

10. Ein Verfahren gemäß Anspruch 1, das ferner nach dem Schritt des Änderns der Hilfsschicht (20, 32) zu der Elektrodenmetallschicht (10a, c, d, e, f, g) auf der dritten Schicht (8) einen Schritt des Einführens von Störstellen (25, 26) in die erste Schicht (3) umfaßt, wobei die Elektrodenmetallschicht auf der dritten Schicht als eine Maske verwendet wird, um den Bereich (3a) der ersten Schicht (3) mit den eingeführten Störstellen zu einer isolierenden Schicht (3b) so zu bilden, daß ein aktiver Bereich der ersten Schicht im wesentlichen dieselbe Größe wie die Elektrodenmetallschicht auf der dritten Schicht erhält.

11. Ein Verfahren gemäß Anspruch 1, das ferner vor dem Schritt des Bildens der Hilfsschicht (20, 32) einen Schritt des Einführens von Störstellen (25, 26) in einen Umfangsteil (14) eines Basisbereiches (4c) der zweiten Schicht (4) umfaßt, um den Umfangsteil (14) zu einer isolierenden Schicht zu bilden, wobei die Hilfsschicht (20, 32) gebildet wird, sich von einem Bereich oberhalb des Basisbereiches (4c) zu einem Bereich oberhalb des Umfangsteils (14) zu erstrecken.

## Revendications

1. Procédé de fabrication d'un transistor bipolaire comprenant les étapes de :
formation d'un matériau structurel multicouche (7) en formant au moins une seconde couche (4) d'un matériau semiconducteur pour former une base et une première couche (23) ainsi qu'une troisième couche (8) d'un matériau semiconducteur possédant des porteurs majoritaires d'un type différent de celui des porteurs majoritaires d'une région de base (4b) de la seconde couche selon une séquence première couche, seconde couche et troisième couche sur un substrat (1) ; et
traitement dudit matériau structurel multicouche (7) selon un transistor bipolaire (4a, 5a, 6a),
caractérisé en ce que l'étape de traitement dudit matériau structurel multicouche selon un transistor bipolaire comprend les étapes de :
formation d'une couche fictive (20, 32) sur la troisième couche (8);
formation d'une protubérance (9) réalisée en le matériau (5) de la troisième couche en gravant la troisième couche en utilisant la couche fictive en tant que masque ; et
conversion de la couche fictive (20, 32) sans modifier la dimension de la couche fictive en une couche métallique d'électrode (10a, c, d, e, f, g) présentant une même dimension que la couche fictive déposée sur la troisième couche ;
dans lequel l'étape de conversion de la couche fictive (20, 32) en la couche métallique d'électrode (10a, c, d, e, f, g) comprend les étapes de :
recouvrement de la surface du matériau structurel multicouche (7) et de la couche fictive avec une résine photosensible (21) ;
gravure par voie sèche de la résine photosensible (21) afin de mettre à nu une surface supérieure (19) de la couche fictive ;
enlèvement de la couche fictive pour former une ouverture (22a) dans laquelle la troisième couche est mise à nu ;
évaporation d'un métal d'électrode sur la troisième couche mise à nu et sur la résine photosensible ;
enlèvement par gravure sous-jacente du métal d'électrode évaporé sur la résine photosensible ; et
enlèvement de la résine photosensible.

2. Procédé selon la revendication 1, dans lequel la troisième couche (8) est gravée en utilisant la couche fictive (20, 32) en tant que masque de telle sorte qu'une région de base externe (4c) de la seconde couche (4) soit mise à nu lors de l'étape de formation de la protubérance (9) réalisée en le matériau (5) de la troisième couche, ledit procédé comprenant en outre une étape d'évaporation d'un métal d'électrode de base (28) sur la région de base externe mise à nu (5c) en utilisant la couche métallique d'électrode (10a, c, d, e, f, g) déposée sur la troisième couche en tant que masque pour former une couche métallique d'électrode de base (11a) sur la région de base externe (4c).

3. Procédé selon la revendication 1, dans lequel la troisième couche (8) est gravée en utilisant la couche fictive (20, 32) en tant que masque de telle sorte qu'une région de base externe (4c) de la seconde couche (4) soit mise à nu lors de l'étape de formation de la protubérance (9) réalisée en le matériau (5) de la troisième couche, ledit procédé comprenant en outre une étape de formation d'une paroi latérale (17) du matériau isolant sur une surface latérale de la protubérance (9) réalisée en le matériau (5) de la troisième couche et sur une surface latérale de la couche métallique d'électrode (10a, c, d, e, f, g) sur la troisième couche, et une étape d'évaporation d'un métal d'électrode de base (28) sur la région de base externe mise à nu (5c) en utilisant la couche métallique d'électrode déposée sur la troisième couche et la paroi latérale (17) du matériau isolant en tant que masque pour former une couche métallique d'électrode de base (11a) sur la région de base externe (4c).

4. Procédé selon la revendication 1, dans lequel la troisième couche (8) est gravée en utilisant la couche fictive (20, 32) en tant que masque de telle sorte qu'une région de base externe (4c) de la seconde couche (4) soit mise à nu lors de l'étape de formation de la protubérance (9) réalisée en le matériau (5) de la troisième couche, ledit procédé comprenant en outre une étape de formation d'une paroi latérale (17) du matériau isolant sur une surface latérale de la protubérance (9) réalisée en le matériau (5) de la troisième couche et sur une surface latérale de la couche métallique d'électrode (10a, c, d, e, f, g) sur la troisième couche, une étape d'évaporation d'un métal d'électrode de base (28) sur la totalité de la surface, une étape de recouvrement de la totalité de la surface du métal d'électrode de base évaporé (11a) avec une résine photosensible (21), une étape de mise à nu de la protubérance (9) qui possède la paroi latérale (17) du matériau isolant par gravure et une étape d'enlèvement du métal d'électrode de base (28) évaporé sur la protubérance (9).

5. Procédé selon la revendication 1, dans lequel la troisième couche (8) est sur-gravée jusqu'au voisinage d'une région de base externe (4c) de la seconde couche (4) en utilisant la couche fictive (20, 32) en tant que masque lors de l'étape de formation de la protubérance (9) réalisée en le matériau (5) de la troisième couche, ledit procédé comprenant en outre une étape de mise à nu de la région de base externe (4c) de la seconde couche (4) au moyen d'une gravure en utilisant la couche métallique d'électrode (10a, c, d, e, f, g) située sur la troisième couche en tant que masque et une étape d'évaporation d'un métal d'électrode de base (28) en utilisant la couche métallique d'électrode déposée sur la troisième couche en tant que masque pour former une couche métallique d'électrode de base (11a) sur la région de base externe mise à nu (4c).

6. Procédé selon la revendication 1, dans lequel la troisième couche (8) est gravée en utilisant la couche fictive (20, 32) en tant que masque de telle sorte qu'une région de base externe (4c) de la seconde couche (4) soit mise à nu lors de l'étape de formation de la protubérance (9) réalisée en le matériau (5) de la troisième couche, ledit procédé comprenant en outre une étape d'évaporation d'un métal d'électrode de base (28) sur la région de base externe mise à nu (5c) en utilisant la couche fictive (20, 32) en tant que masque pour former une couche métallique d'électrode de base (11a) sur la région de base externe (4c).

7. Procédé selon la revendication 1, dans lequel la troisième couche (8) est gravée en utilisant la couche fictive (20, 32) en tant que masque de telle sorte qu'une région de base externe (4c) de la seconde couche (4) soit mise à nu lors de l'étape de formation de la protubérance (9) réalisée en le matériau (5) de la troisième couche, ledit procédé comprenant en outre, avant l'étape de conversion de la couche fictive en la couche métallique d'électrode (10a, c, d, e, f, g) sur la troisième couche, une étape de formation d'une paroi latérale (17) du matériau isolant sur une surface latérale de la protubérance (9) réalisée en le matériau (5) de la troisième couche et sur une surface latérale de la couche fictive (20, 32), une étape d'évaporation d'un métal d'électrode de base (28) sur la totalité de la surface, une étape de recouvrement de la totalité de la surface du métal d'électrode de base évaporé avec une résine photosensible (21), une étape de mise à nu de la surface supérieure (19) de la couche fictive (20, 32) par gravure, une étape d'enlèvement du métal d'électrode de base évaporé sur la paroi latérale (17) du matériau isolant et une étape d'enlèvement de la paroi latérale du matériau isolant.

8. Procédé selon la revendication 1, comprenant en outre, avant l'étape de conversion de la couche fictive (20, 32) en la couche métallique d'électrode (10a, c, d, e, f, g) sur la troisième couche (8), une étape d'introduction d'impuretés (24) dans la seconde couche (4) en utilisant la couche fictive (20, 32) en tant que masque de manière à former la partie à impuretés introduites (4c) de la seconde couche dans une région de base externe à résistance faible.

9. Procédé selon la revendication 1, comprenant en outre, avant l'étape de conversion de la couche fictive (20, 32) en la couche métallique d'électrode (10a, c, d, e, f, g) sur la troisième couche (8), une étape d'introduction d'impuretés (24) dans la première couche (3) en utilisant la couche fictive (20, 32) en tant que masque pour former la partie à impuretés introduites (3a) de la première couche (3) dans une couche isolante (3b) de telle sorte qu'une partie active de la première couche prenne sensiblement la même dimension que la couche fictive.

10. Procédé selon la revendication 1, comprenant en outre, après l'étape de conversion de la couche fictive (20, 32) en la couche métallique d'électrode (10a, c, d, e, f, g) sur la troisième couche (8), une étape d'introduction d'impuretés (25, 26) dans la première couche (3) en utilisant la couche métallique d'électrode sur la troisième couche en tant que masque pour former la partie à impuretés introduites (3a) de la première couche (3) dans une couche isolante (3b) de telle sorte qu'une partie active de la première couche prenne sensiblement la même dimension que la couche métallique d'électrode sur la troisième couche

11. Procédé selon la revendication 1, comprenant en outre, avant l'étape de formation de la couche fictive (20, 32), une étape d'introduction d'impuretés (25, 26) dans une partie périphérique (14) d'une région de base (4c) de la seconde couche (4) afin de former la partie périphérique (14) dans une couche isolante, dans lequel la couche fictive (20, 32) est formée de manière à s'étendre depuis une partie située au-dessus de la région de base (4c) jusqu'à une partie située au-dessus de la partie périphérique (14).
